# EUROPEAN PATENT SPECIFICATION

(11) **EP 2 130 393 B1**
(45) Date of publication and mention of the grant of the patent: **11.01.2017**
(21) Application number: 08724326.7
(22) Date of filing: 02.04.2008
(51) Int. Cl.: H04M 1/18, H04B 1/3816, H01L 23/495, H04M 1/02

(54) **IDENTITY CARRIER**
IDENTITÄTSTRÄGER
SUPPORT D'IDENTITÉ

(30) Priority: 05.04.2007 SE 0700861; 11.04.2007 US 911202 P
(43) Date of publication of application: 09.12.2009
(73) Proprietor: PostNord Strålfors Group AB, 341 84 Ljungby (SE); Telenor Sverige Ab, 371 80 Karlskrona (SE)
(72) Inventor: JOHANSSON, Mikael, S-269 35 Båstad (SE)
(74) Representative: Valea AB
(86) International application number: PCT/SE2008/050380
(87) International publication number: WO 2008/123827

(56) References cited:
- WO-A2-2006/003548
- DE-A1- 10 004 164
- DE-U1-202004 017 350
- FR-A1- 2 843 513
- FR-A1- 2 843 513
- FR-A1- 2 843 521
- US-B1- 6 376 283

## Description

### Technical field

The present invention relates to an identity carrier in a telematic system.

### State of the art

A known practice is to use the mobile telephone network in a so-called telematic system, i.e. to use the mobile telephone network for transmission of some kind of data/information to or from a call unit provided with a wireless telematic unit via the telephone network to a receiver unit connected to the telephone network via the mobile or the fixed telephone network.

The data/information transmitted may for example come from some form of sensor or application at or connected to the call unit.

The receiver unit may for example be provided with means or devices for gathering and/or further processing of data and, where applicable, for passing on or sending back instructions or data based on gathered and/or processed data/information.

The expression telematic system as used here also comprises applications such as telemetry, M2M (machine-to-machine), telemedicine, alarms etc. and both one-way and two-way communication.

A central element of a telematic unit intended for use on the mobile telephone network is the SIM (subscriber identity module) carrying the identity which in the mobile telephone network identifies the particular telematic unit and its subscription at an operator.

In the state of the art, the telematic unit is provided with a standardised SIM card placed in a standard holder which is usually on a circuit card (also known as circuit board) together with other electronic components. On the SIM card there are contact surfaces against which spring-loaded contact strips of the holder abut in order to connect the circuit card to an underlying chip which comprises the SIM circuit.

The SIM card is a support made of plastic and is often a stamped-out part of a credit card-sized plastic card. A recess is cut in one of the main surfaces of the support to accommodate a chip from a so-called wafer. In the manufacture of a SIM card, the chip is usually first placed on a foil with a plurality of electrical conducting fields, some of which are put into conducting connection with the chip's contact points, e.g. by so-called bonding wires. Placing the chip thereafter in the plastic card's recess with the foil on top, covering the chip and the recess, provides via the fields of the foil the contact surfaces against which the holder's contact devices can thereafter abut.

To activate a SIM card, it has to be personalised, i.e. provided with one or more identities for identification in a network.

Examples which may be mentioned of areas in which telematic units are used or can be used in conjunction with alarms and/or sensors comprise: use in vehicles to provide alarms in the event of accident or theft and to indicate vehicle location; use in property for reading electricity and water meters and providing alarms in the event of fire or burglary; use in industry for breakdown alarms, process monitoring, follow-up of goods location and goods environment (e.g. refrigerated transport), transmission of machine data; use in medicine for remote monitoring of patients, etc.

WO 2006/003548 describes a chip card for insertion into a holder. A chip is encapsulated and contact pads are arranged to provide electric contact between the chip and a holder.

### Problems

A problem of the state of the art is ensuring contact and hence functionality in the connections between SIM cards and SIM cardholders. This applies particularly in the case of telematic units intended for use in so-called aggressive environments, e.g. environments showing one or more of the following features; corrosive, vibrating, dusty, damp etc. with consequent heightening of such risks as oxidation and mechanical fatigue.

Many applications also call for very high reliability, e.g. fire alarms, safety alarms, breakdown warnings etc. Such forms of communication are also used rarely, which means that a contact problem may well remain unnoticed for long periods.

Another problem arises in applications where the unit is subject to high temperatures at which the plastic used as support in traditional SIM cards softens.

A further problem of the state of the art is the large size of a SIM card relative to other electronic components on a circuit card in a telematic unit. As electronic components generally have become smaller, the relative size of a SIM card has increased markedly in recent times, thereby exacerbating the problem.

A further problem is the risk of theft of SIM cards from telematic units, since people may be tempted to steal the SIM card and try to place it in a mobile telephone for "cost-free" calls.

### Object of the invention

An object of the present invention is to alleviate or overcome the aforesaid problems or shortcomings of the state of the art.

### Summary of the invention

This object is achieved with devices, methods and uses as first mentioned above which exhibit the features defined in the independent claim set out below.

An identity carrier (subscriber identifier) configured for interaction with a telematic unit according to the present invention can replace a SIM for identifying a subscriber in the mobile telephone network. The identity carrier comprises a chip which has a configuration capable of being personalised and being connected to a subscription at a telecommunications operator, a shell bearing the chip, and connecting means connected permanently to the chip's connection points and rendering them connectable, whereby the shell is arranged to enclose the chip and the connecting means are arranged to extend through said shell to a connectable location outside the shell and arranged for firm assembly to a circuit card in the telematics unit. The connecting means are adapted to being bonded or soldered permanently and to bearing, in an assembled state, the identity carrier. Problems with aggressive environments will thus be reduced.

The connecting means may comprise legs protruding freely through the shell at a distance from one another, thereby reducing sensitivity to high temperatures.

The connecting means may further be arranged for surface mounting, which is a rational and space-saving way of permanently fitting components.

The identity carrier may also have external dimensions conforming to some standard applicable at the time to electronic components. The standard concerned may be official or practical/factual, making it possible for such an identity carrier to be handled effectively in so-called pick-and-place mechanical equipment.

The identity carrier may further have dimensions conforming to electronic component standard SO8.

A method for making an identity carrier as summarized above may comprise steps of detaching from a wafer a chip intended to be personalised, of permanently connecting electrically conducting connecting means to the chip's contact points and of causing an electrically insulating shell to enclose the chip and fit tightly round connecting means extending through the enclosure, and arranged for firm assembly to a circuit card in the telematics unit. The connecting means are adapted to being bonded or soldered permanently and to bearing, in an assembled state, the identity carrier.

Individual identity carriers may further be placed at certain distances and in certain positions in a standardised delivery support.

The invention further relates to the use of an identity carrier as above in a telematic unit, as well a a telematics unit comprising an identity carrier.

These and further objects, features and advantages of the invention are indicated in the detailed description set out below of preferred embodiments of the invention, which constitute examples and therefore do not limit the extent of protection of the invention.

### Brief description of the drawings

Fig. 1 show schematically two types of telematic entities in a mobile telephone network.
Fig. 2 depicts schematically, in perspective and partly cut away an identity carrier unit according to an embodiment of the present invention.

### Detailed description of embodiments

For the sake of clarity, the following detailed description adopts in certain cases expressions and designations for constituent parts which are appropriate to the embodiment example depicted. These expressions and designations are therefore not to imply limitations during interpretation of the expressions and designations used in the claims for describing the extent of protection of the invention.

In a preferred embodiment of the invention, problems of reliability and size in a telematic application are solved by the traditional SIM card and its holder being replaced by an identity capsule for direct assembly to a circuit card.

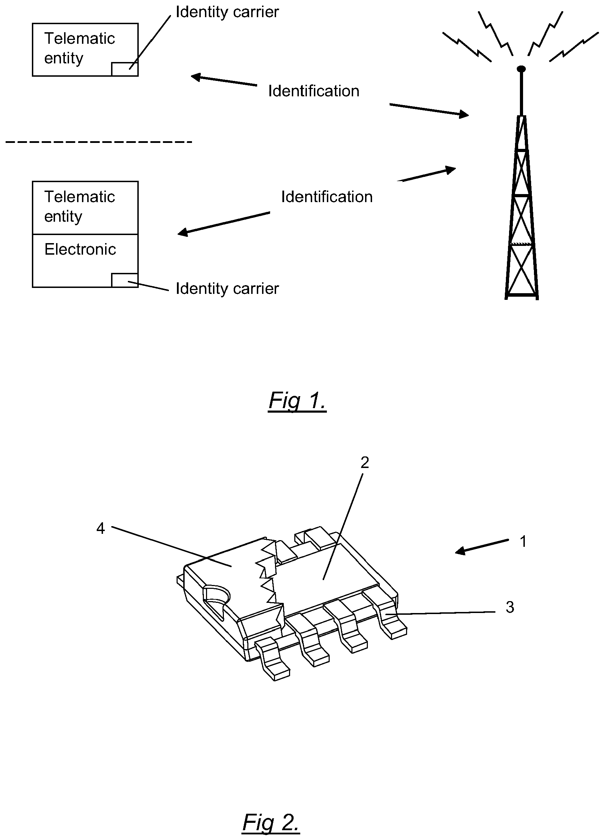

The identity capsule 1 according to the embodiment in fig. 2, comprises a chip 2 having a configuration which is suitable for personalisation and takes the form here of a SIM circuit. The chip 2 has its contact points connected by so-called bonding wires to electrically conducting legs 3. The chip 2 is further enclosed by a shell 4 of polymer/plastic material and in fig. 2 for illustration only partly cut away. The shell 4, which here is an example of a support, encloses the chip 2 completely and also fits tightly round the legs 3 protruding through the shell 4. The legs render the chip connectable to a circuit card. The legs constitute an example of connecting means and may be intended to be soldered or bonded or otherwise permanently connected to a circuit card or substrate for assembly alone or, more likely, together with other electronic components.

As an alternative, other embodiments may use a so-called baseplate for safely but releasably connecting the legs to the circuit card. Such a baseplate is soldered or bonded to a circuit card or substrate and the legs of the identity capsule are gripped by electronically conducting fastening means.

Chips are usually made from a so-called wafer, a larger disc which is divided to produce the individual chips.

In an alternative embodiment, the identity capsule is configured according to some standard intended for electronic components with regard to external design, which standard may be official or practical/factual. Standard here means a standard adopted by an official standards publication or a standard which is developed by extensive practical use or by certain standard dimensions or values being required for use in a certain type or series of mechanical equipment. The latter kind is also sometimes called a de facto standard or factual standard. An identity capsule made to a standard will be suitable for rational handling by mechanical handling equipment available on the market.

A known way of achieving production rationality is by using programmable robots and/or so-called pick-and-place equipment for rapid handling of small electronic components. Such machines often call for components to be placed on a standardised delivery support so that the machine knows where the components are and how they are oriented. Such delivery supports may be trays, tapes, pipes/tubes etc. whereby the positions of components can be predicted.

If a group of identity capsules is placed on such a delivery support, e.g. a tape, they can be loaded in an automatic personalisation unit where a pick-and-place module will take an identity capsule from the delivery support and place it in position for programming in a device intended for the purpose. When the programming and any physical marking have been completed, the pick-and-place module will take the identity capsule and place it on a delivery support for further transfer, e.g. to the assembling of a telematic unit. This latter delivery support may or may not be the same as that from which the identity capsule was taken before the personalisation, and it may also be of a different type.

Thereafter, during the manufacture of a telematic unit, standardised pick-and-place equipment may also be used for placing the identity capsule on the circuit card or substrate, thereby clearly making the assembly process more efficient and greatly reducing the space required on the circuit card as against a traditional SIM card with a holder.

In an alternative embodiment, the identity capsule's legs are designed for surface mounting and are manufactured in dimensions according to S08 so that they can be delivered on a tape in a roll according to standard for subsequent work operations, i.e. personalisation and/or assembly. One skilled in the art will readily appreciate that from time to time, depending on application and surrounding components, some other suitable standard for the identity carrier may be adopted.

Using an identity capsule according to an embodiment of the present invention thus eliminates the risk of oxidation and loose contact with preloaded contact strips in a SIM cardholder and ensures electrical conduction between the identity carrier and other electronics.

The space which the identity carrier occupies on a circuit card is also reduced. A traditional SIM card placed in a holder measures about 25 x 15 mm, whereas an identity carrier according to an embodiment of the present invention whereby the capsule is designed to standard S08 will measure only about 4 x 5 mm. S08 is mentioned as a possible standard and as a concrete example of the order of magnitude of the size reduction. It will be obvious to one skilled in the art that there are other standards for electronic components - existing or future - which may be applied and S08 is therefore to be regarded as an example and not as limiting the extent of protection of the present invention.

Likewise, the shell here described as being made of polymer/plastic is not to be interpreted as excluding other materials suitable for shells. The shell is intended to protect what is enclosed and to prevent undesirable short-circuiting between different conductors of the connecting means.

The fact that the chip is encased in a shell and that the telematic unit can thereafter likewise be of an encased design increases the number of possible applications for the telematic unit in the mobile telephone network. Sensitivity to temperature changes, dust, vibrations, dirt etc. is markedly reduced.

## Claims

1. An identity carrier configured for interaction with a telematic unit for subscriber identification in a mobile telephone network comprising a chip (2) which has a configuration capable of being personalised and of being connected to a subscription at a telecommunications operator, a shell (4) bearing the chip, and connecting means (3) permanently connected to the chip's connection points and rendering them connectable, **characterised in that** the shell (4) is arranged to enclose the chip (2) and that the connecting means (3) are arranged to extend through said shell (4) to a connectable location outside the shell (4) and arranged for firm assembly to a circuit card in the telematics unit, where the connecting means (3) are adapted to be bonded or soldered permanently and that the connecting means (3) in a fitted state are adapted to bear the identity carrier.

2. An identity carrier according to claim 1, where the connecting means comprise legs (3) which protrude freely through the shell (4) at a distance from one another.

3. An identity carrier according to any of claims 1 - 2, where the connecting means (3) are arranged for surface mounting.

4. An identity carrier according to any one of the foregoing claims, where the identity carrier has external dimensions conforming to some standard, official or practical/factual, applicable at the time to electronic components, whereby such an identity carrier can be handled in so-called pick-and-place mechanical equipment.

5. An identity carrier according to claim 4, where the identity carrier has dimensions conforming to electronic component standard S08.

6. A method for production of an identity carrier configured for interaction with a telematic unit for subscriber identification in mobile telephone network, comprising steps of detaching from a wafer a chip (2) intended to be personalised and of permanently connecting electrically conducting connecting means (3) to the chip's contact points, **characterised in that** an electrically insulating shell (4) is caused to enclose the chip (2) and fit tightly round connecting means (3) which extend through the shell (4) to a connectable location outside the shell (4) and arranged for firm assembly to a circuit card in the telematics unit, where the connecting means (3) are adapted to be bonded or soldered permanently and that the connecting means (3) in a fitted state are adapted to bear bearing the identity carrier..

7. A method according to claim 6, where individual identity carriers are placed at specified distances and in specified positions on a standardised delivery support.

8. Use of an identity carrier according to any one of claims 1-5 in a telematic unit.

9. Telematic unit comprising an identity carrier according to any of claims 1-5.

## Patentansprüche

1. Identitätsträger, ausgebildet zur Wechselwirkung mit einer Telematikeinheit zur Teilnehmeridentifizierung in einem Mobilfunknetz, umfassend einen Chip (2) mit einer Konfiguration, die personalisierbar ist und die mit einem Abonnement bei einem Telekommunikationsbetreiber verbindbar ist, ein Gehäuse (4), das den Chip trägt, und Verbindungsmittel (3), die permanent mit den Verbindungspunkten des Chips verbunden sind und diese verbindbar machen,
**dadurch gekennzeichnet, dass** das Gehäuse (4) ausgebildet ist, den Chip (2) zu umschließen, und dass die Verbindungsmittel (3) ausgebildet sind, sich durch das Gehäuse (4) zu einer verbindbaren Stelle außerhalb des Gehäuses (4) zu erstrecken und zur festen Montage auf einer Leiterplatte in der Telematikeinheit ausgebildet sind, wobei die Verbindungsmittel (3) ausgebildet sind, um permanent verbunden oder verlötet zu werden, und dass die Verbindungsmittel (3) in einem eingebauten Zustand zum Tragen des Identitätsträgers ausgebildet sind.

2. Identitätsträger nach Anspruch 1, wobei die Verbindungsmittel Beine (3) umfassen, die frei durch das Gehäuse (4) beabstandet voneinander hindurchragen.

3. Identitätsträger nach einem der Ansprüche 1-2, wobei die Verbindungsmittel (3) zur Oberflächenmontage ausgebildet sind.

4. Identitätsträger nach einem der vorhergehenden Ansprüche, wobei der Identitätsträger äußere Abmessungen aufweist, die einer Norm entsprechen, die offiziell oder praktisch/tastsächlich zu der Zeit auf elektronische Komponenten anwendbar ist, wobei solch ein Identitätsträger gehandhabt werden kann in sogenannten Pick-und-Place mechanischen Bestückungsvorrichtungen.

5. Identitätsträger nach Anspruch 4, wobei der Identitätsträger Abmessungen aufweist, die einer Norm für elektronische Komponenten SO8 entsprechen.

6. Verfahren zur Herstellung eines Identitätsträgers, ausgebildet zur Wechselwirkung mit einer Telematikeinheit zur Teilnehmeridentifizierung in einem Mobilfunknetz, umfassend die Schritte Lösen eines Chips (2), vorgesehen personalisiert zu werden, von einem Wafer und Verbinden elektrisch leitender Verbindungsmittel (3) mit den Kontaktpunkten des Chips,
**dadurch gekennzeichnet, dass** ein elektrisch isolierendes Gehäuse (4) veranlasst wird, den Chip (2) zu umschließen und eng um die Verbindungsmittel (3), die sich durch das Gehäuse (4) zu einer verbindbaren Stelle außerhalb des Gehäuses (4) erstrecken und die zur festen Montage auf einer Leiterplatte in der Telematikeinheit ausgebildet sind, herum anzupassen, wobei die Verbindungsmittel (3) ausgebildet sind, um permanent verbunden oder verlötet zu werden, und dass die Verbindungsmittel (3) in einem eingebauten Zustand zum Tragen des Identitätsträgers ausgebildet sind.

7. Verfahren nach Anspruch 6, wobei individuelle Identitätsträger in bestimmten Abständen und in bestimmten Positionen auf einem standardisierten Lieferträger platziert sind.

8. Verwendung eines Identitätsträgers nach einem der Ansprüche 1-5 in einer Telematikeinheit.

9. Telematikeinheit, umfassend einen Identitätsträger nach einem der Ansprüche 1-5.

## Revendications

1. Support d'identité configuré pour interagir avec une unité télématique pour identification d'un abonné dans un réseau téléphonique mobile comprenant une puce (2) qui présente une configuration susceptible d'être personnalisée et d'être connectée à un abonnement chez un opérateur de télécommunications, une coque (4) maintenant la puce, et des moyens de connexion (3) connectés de façon permanente aux points de connexion de la puce et les rendant connectables, **caractérisé en ce que** la coque (4) est conçue pour enfermer la puce (2) et **en ce que** les moyens de connexion (3) sont conçus pour s'étendre à travers ladite coque (4) vers un emplacement connectable extérieur à la coque (4) et conçus pour un assemblage solide à une carte à circuits dans l'unité télématique, où les moyens de connexion (3) sont adaptés pour être collés ou soudés de façon permanente et **en ce que** les moyens de connexion (3) dans un état ajusté sont adaptés pour maintenir le support d'identité.

2. Support d'identité selon la revendication 1, où les moyens de connexion comprennent des pattes (3) qui font saillie librement à travers la coque (4) à distance les unes des autres.

3. Support d'identité selon l'une des revendications 1 et 2, où les moyens de connexion (3) sont conçus pour un montage en surface.

4. Support d'identité selon l'une quelconque des revendications précédentes, où le support d'identité a des dimensions externes se conformant à une certaine norme, officielle ou pratique/factuelle, applicable actuellement aux composants électroniques, moyennant quoi un tel support d'identité peut être manipulé dans le dénommé équipement mécanique de manutention.

5. Support d'identité selon la revendication 4, où le support d'identité a des dimensions se conformant à la norme des composants électroniques SO8.

6. Procédé de production d'un support d'identité configuré pour interagir avec une unité télématique pour identification d'un abonné dans un réseau téléphonique mobile, comprenant les étapes de détachement d'une tranche d'une puce (2) destinée à être personnalisée et de connexion permanente de moyens de connexion électroconducteurs (3) aux points de contact de la puce, **caractérisé en ce qu'**une coque électro-isolante (4) est amenée à enfermer la puce (2) et à s'ajuster étroitement autour des moyens de connexion (3) qui s'étendent à travers la coque (4) vers un emplacement connectable extérieur à la coque (4) et sont conçus pour un assemblage solide à une carte à circuits dans l'unité télématique, où les moyens de connexion (3) sont adaptés pour être collés ou soudés de façon permanente et **en ce que** les moyens de connexion (3) dans un état ajusté sont adaptés pour soutenir le support d'identité.

7. Procédé selon la revendication 6, où les supports d'identité individuels sont placés à des distances spécifiées et dans des positions spécifiées sur un support de distribution normalisé.

8. Utilisation d'un support d'identité selon l'une quelconque des revendications 1 à 5 dans une unité télématique.

9. Unité télématique comprenant un support d'identité selon l'une quelconque des revendications 1 à 5.
